# EUROPÄISCHE PATENTSCHRIFT

(11) **EP 2 284 436 B1**
(45) Veröffentlichungstag und Bekanntmachung des Hinweises auf die Patenterteilung: **08.02.2012**
(21) Anmeldenummer: 09010117.1
(22) Anmeldetag: 05.08.2009
(51) Int. Cl.: F21V 5/04, G02B 7/02, G02B 7/20, G02B 27/09

(54) **Vorrichtung zur Erzeugung eines im wesentlichen linearen Lichtstrahls mit geringer lateraler Ausbreitung**
Device for generating a largely linear beam of light with low lateral spread
Dispositif de production d'un rayon lumineux essentiellement linéaire ayant un élargissement latéral réduit

(43) Veröffentlichungstag der Anmeldung: 16.02.2011
(73) Patentinhaber: Stapelfeldt, Kai, 22559 Hamburg (DE)
(72) Erfinder: Stapelfeldt, Kai, 22559 Hamburg (DE)
(74) Vertreter: Niedmers, Ole

(56) Entgegenhaltungen:
- EP-A- 0 269 122
- WO-A-03/009040
- DE-A1- 10 107 487
- US-A- 4 919 506

## Beschreibung

Die Erfindung betrifft eine Vorrichtung zur Erzeugung eines im wesentlichen linearen Lichtstrahls mit geringer lateraler Ausbreitung, umfassend eine Lichtquelle, deren Lichtstrahlen auf eine Focussierungseinrichtung geleitet werden, und im Strahlengang zwischen Linse und Lichtquelle und im Strahlengang nach der Linse jeweils eine schlitzförmig ausgebildete Blende angeordnet ist, wobei die die Focussierungseinrichtung in Form der Linse verlassenden Lichtstrahlen das gewünschte Licht bilden.

Eine Vorrichtung dieser Art ist bekannt (EP-A-0 269 122). Die bekannte Vorrichtung bezieht sich auf ein laseroptisches System, bei dem in dem Augenblick, wo der Laserstrahl aus einer Laserstrahlquelle austritt, um den Laserstrahl keine Strahlungskeule erzeugt wird. Die bekannte Vorrichtung wird u.a. in Einrichtungen verwendet, in denen ein Lichtstrahl zum Scannen, bspw. zum optischen Auslesen von Informationen, verwendet wird. Ein Laserstrahl mit Strahlungskeule wäre dafür ungeeignet.

Eine weitere Vorrichtung ähnlicher Art ist aus der DE-A-101 07 487 bekannt. In vielen Bereichen der gewerblichen Wirtschaft aber auch zunehmend im privaten Bereich, bspw. auch bei den immer professioneller und aufwendiger werdenden Maschinen, bei denen bzw. mit denen auch Abstands- und Dickenmessungen von Gegenständen durchgeführt werden, wird Licht bzw. kohärentes Licht, verwendet. Da auch durch die rasant fortschreitende Entwicklung von immer leistungsfähigeren Lichtquellen auf der Basis von Halbleitern große technologische Fortschritte gemacht worden sind und mittels Halbleitern erzeugtes Licht sogar schon Eingang in Scheinwerferlichtquellen von Automobilen gefunden hat, wird diese Technik kontinuierlich weiterentwickelt. Grundsätzlich gilt, daß im wesentlichen alle Lichtquellen, ob nun herkömmlicher Art wie Leuchtmittel auf der Basis von Glühdrähten oder aber Gasentladungslampen (Leuchtstofflampen) und auch Leuchtmittel auf der Basis von Halbleitern, für viele mögliche Anwendungszwecke den außerordentlich großen Nachteil haben, daß das von diesen Lichtquellen ausgesendete Licht im wesentlichen isotrop ausgesendet wird. Für Meß-, Kontroll- und Steuerungsfunktionen ist das die Lichtquellen im wesentlichen isotrop verlassende Licht technisch nicht zu gebrauchen, wobei die physikalischen Techniken, die daraus bestimmte Anteile mit kleineren Abstrahlwinkeln als gewünscht herauszufiltern und ggf. den zu nutzenden Lichtanteil zu parallelisieren und zu focussieren bzw. umgekehrt, erst zu focussieren und dann zu parallelisieren, bekannt sind.

Es ist der Fachwelt bekannt, daß eine Focussierung und Parallelisierung, um Lichtstrahlen mit geringer lateraler Breite bzw. einem geringen Strahlendurchmesser zu bekommen, apparativ um so aufwendiger sind, je größer die Anforderungen sind, eine geringe laterale Breite der Lichtstrahlen bzw, des Lichtstrahlbündels zu erreichen und dabei eine weitgehende Parallelität der Lichtstrahlen sicherzustellen. Leuchtmittel auf der Basis von Halbleitern sind bspw. im Ergebnis heutzutage Massenprodukte mit verhältnismäßig geringen Gestehungskosten, sie haben aber die vorangehend aufgeführten Nachteile und können für die industrielle aber auch die private Anwendung nur dann herangezogen werden, wenn das derartige Leuchtmittel verlassende Licht durch ein Linsensystem und/oder ein Blendensystem "behandelt" wird, so daß es dann für die besagten Zwecke zur Verfügung steht. Es ist mit anderen Worten, für die genannten Zwecke das Bestreben, immer möglichst viel Licht zu sammeln und nachfolgend zu bündeln.

Leider weisen Leuchtmittel in bezug auf ihre Lichtaustrittsöffnungen bzw. Lichtaustrittsflächen sehr große Abweichungen auf, so daß die einfache Methodik und der einfache Aufbau einer dazu bestimmten Vorrichtung in bestimmten Fällen nicht ausreicht, bspw. wie in der beschriebenen DE-A-101 07 487, eine gewünschte geringe laterale Breite des diese Vorrichtung verlassenden Lichts zu gewährleisten. Ein wesentlicher Grund dafür ist, daß die herstellungsbedingte Streuung des die Lichtquelle verlassenden Lichts im Hinblick auf Austrittsöffnung, Austrittswinkel und Intensität, da es sich, wie gesagt, um Massenprodukte handelt, sehr groß ist und somit für bestimmte Anwendungszwecke die gem. der DE-A-101 07 487 vorgeschlagenen Maßnahmen nicht in jedem Falle ausreichen.

Es ist somit die Aufgabe der vorliegenden Erfindung, eine Vorrichtung zur Erzeugung eines im wesentlichen linearen Lichtstrahls mit geringer lateraler Ausbreitung zu schaffen, die eine Lichtquelle umfaßt, deren Lichtstrahlen auf eine Focussierungseinrichtung geleitet werden, wobei die diese verlassenden Lichtstrahlen das gewünschte Licht bilden, und wobei diese Vorrichtung die Leistungsfähigkeit bekannter Vorrichtungen dieser Art erheblich übertrifft, und zwar bei angestrebtem einfachen und damit kostengünstig bereitstellbarem Aufbau, so daß Lichtquellen darin Verwendung finden können, die, durch den Fertigungsprozeß bedingt, große Schwankungsbreiten im Hinblick auf die Lichtaustrittsöffnung, den Lichtaustrittsraumwinkel bzw. -raumwinkelbereich und die Lichtintensität, die diese Lichtquellen als Massenprodukte nominell abzugeben im Stande sind, normalerweise aufweisen und an sich jeweilige angestrebte Größen überschreiten.

Gelöst wird die Aufgabe gem. der Erfindung dadurch, daß die Linse in Form einer Kugel ausgebildet ist und die Schlitze in einem Rohrelement mit kreisförmigem Querschnitt angeordnet sind, in dessen Innenraum die kugelförmige Linse spielfrei aufgenommen ist, wobei das Rohrelement relativ zur Linse um seine im wesentlichen orthogonal 1 zur Achse des Strahlenganges verlaufende Längsachse drehbar ist und die Blende in Form einer Durchbrechung der Rohrwandung ausgebildet ist.

Dadurch, daß die die Blenden bildenden Schlitze in einem Rohrelement angeordnet sind, in dessen Innenraum die kugelförmige Linse aufgenommen wird bzw. ist, und das Rohrelement relativ zur kugelförmigen Linse um eine im wesentlichen orthogonal zur Achse des Strahlenganges verlaufende Drehachse drehbar ist, kann auf sehr einfache Weise, d.h. durch Verdrehung des Rohrelementes, eine Ausrichtung des Mittelpunktes der Lichtquelle bei mechanisch feststehender Achslage der Kugellinse mit hoher Genauigkeit erreicht werden. Durch die Blendenanordnung werden nur die Strahlen durchgelassen, welche der Achsmitte von Strahlungsquelle und Linse entsprechen.

Die erfindungsgemäße Lösung hat zudem den sehr großen Vorteil, daß die an erster Stelle für die extreme Streuung der Lichtaustrittsöffnungen der Lichtquellen verantwortlichen Gehäuse und dgl., in dem aufgenommen diese Lichtquellen nach der Fertigung bereitgestellt werden, keine Auswirkungen auf die Parallelität der die Vorrichtung verlassenden Lichtstrahlen haben. Wenn die im Gehäuse aufgenommenen Lichtquellen an einem vorbestimmten Ort auf einem Träger, der auch bspw. eine mechanisch stabile elektrische Schaltung sein kann, eine konstruktions- und fertigungsbedingte Abweichung zwischen der optischen Achse der Lichtquelle und einer mechanischen Achse, die vorgegeben ist, zeigen, die aber zur bestimmungsgemäßen Funktion der Vorrichtung übereinstimmen müssen, können diese nicht in Übereinstimmung gebracht werden.

Die z.Z. üblicherweise in den Kollimatoren verwendeten Linsen weisen einen Rand zur Einfassung oder eine definierte Auflage (plankonvexe Linse) auf, was zur Folge hat, daß die Kollimatoren einen relativ großen Außendurchmesser aufweisen. Der minimale Außendurchmesser eines Kollimators ergibt sich aus dem Durchmesser des die Lichtquelle aufnehmenden Gehäuses und dem Abstand eines Trägers zur Aufnahme der Lichtquelle zur Oberkante des eigentlichen Gehäuses der Lichtquelle. Durch diesen Abstand wird die minimale Brennweite festgelegt.

Prinzipiell eignen sich für die Ausbildung der Erfindung beliebige Arten von Lichtquellen, wobei vorzugsweise Halbleiterlichtquellen Verwendung finden, die aufgrund neuer Entwicklungen an die Lichtstärke herkömmlicher Leuchtmittel mit Leuchtwendel oder Gasentladungslampen herankommen und diese vielfach bei sehr viel geringerer Leistungsaufnahme weit übertreffen und mechanisch sehr klein ausgebildet werden können. Für viele Zwecke ist es ganz besonders vorteilhaft, die Lichtquelle in Form einer Laserlichtquelle auszubilden, denn das Laserlicht als kohärentes Licht eignet sich für die eingangs skizzierten Meßzwecke, für die die erfindungsgemäße Vorrichtung herangezogen werden soll, außerordentlich gut. Dabei ist es von sehr großem Vorteil, als Laserlichtquelle eine Laserdiode zu verwenden, mittels der bei sehr geringen Gestehungskosten außerordentlich leistungsfähige Laserlichtquellen bereitgestellt werden können, die zudem noch den Vorteil haben, daß sie mechanisch sehr klein ausgebildet werden können und sich deshalb bei relativ geringer Leistungsaufnahme auch problemlos in integrierte Schaltungen einfügen lassen und faktisch nur in vernachlässigbarem Umfang Wärme entwickeln.

Die Ausrichtungsgenauigkeit der mechanischen Achslage der Kugellinse zum Mittelpunkt der Lichtquelle, der letztlich nur ein gedachter, idealisierter Punkt ist, ist fertigungsbedingt teilweise erheblichen Schwankungen unterworfen, so daß mittels der Blenden eine ideale Achslage des Strahlenganges des Lichts von der Lichtquelle zum idealisiert im Mittelpunkt der Kugellinse liegenden Mittelpunkt eingestellt werden kann, was dadurch noch vorteilhafter geschehen kann, wenn der blendenbildende Schlitz auf der einen Seite der Focussierungseinrichtung gegenüber dem auf der anderen Seite der Focussierungseinrichtung angeordneten Schlitz um einen im wesentlichen rechten Winkel gedreht ist.

Ganz besonders vorteilhaft ist es, wenn der blendenbildende Schlitz auf der der Lichtquelle zugewandten Seite der Focussierungseinrichtung gegenüber einer zur Richtung des Strahlenganges Orthogonalen um einen Winkel gedreht ist.

Da durch die Kopplung beider Blenden, sie sind beide in dem Rohrelement ausgebildet, eine Verdrehung des Rohrelementes und somit der Blenden relativ zur Strahlenachse durch diese vorangehend erwähnte Ausgestaltung der blendenbildenden Schlitze erfolgt, verlassen die Lichtstrahlen die zweite Blende nur in dem gedachten Flächen- bzw. Öffnungsbereich, der beiden Öffnungen der Schlitze gemeinsam ist. Die Justierung erfolgt somit in einem Schritt und ist dann abgeschlossen.

Es hat sich herausgestellt, daß vorzugsweise dieser Winkel im Bereich von 45° groß ist. Denkbar sind aber auch andere Winkel, insbesondere dann, wenn bspw. die aus der Focussierungseinrichtung austretenden Lichtstrahlen, die das vorrichtungsseitig zu erzeugende Licht bilden, eine bestimmte andere Querschnittsform für bestimmte Erfordernisse aufweisen soll.

Ganz besonders vorteilhaft ist es, wenn die Vorrichtung derart weitergebildet wird, daß wenigstens die Kugellinse in einem in dem Trägerelement ausgebildeten, im wesentlichen kreisförmigen Loch aufgenommen wird, wodurch nämlich die Lage der kugelförmigen Linse relativ zur Lichtquelle unverrückbar fixiert wird, und zwar eben aufgrund ihrer Aufnahme in dem im wesentlichen kreisförmigen Loch selbstzentrierend, so daß keine aufwendigen Zentrierungsmaßnahmen vorgenommen werden müssen.

Um die Stabilität der Vorrichtung, womit in erster Linie die Stabilität im Hinblick auf die Unverrückbarkeit des Strahlenganges der die Vorrichtung verlassenden, bestimmungsgemäß ausgebildeten Lichtstrahlen gemeint ist, die fortwährend zu gewährleisten ist, ist auf dem Trägerelement ebenfalls die Lichtquelle angeordnet, so daß Lichtquelle und Linse und Blenden mechanisch stabil fixiert sind und ebenfalls relativ zueinander stabil fixiert gehalten werden.

Die erfindungsgemäße Vorrichtung eignet sich, wie vorangehend erwähnt, zum bestimmungsgemäßen Betrieb mit unterschiedlich ausgebildeten Lichtquellen. Viele Lichtquellen, die heutzutage in vorkonfektionierter Form im Handel erhältlich sind, sind in Gehäusen bzw. Halterungen verfügbar, die von der Halbleiterindustrie für integrierte Schaltkreise bzw. Tansistoren und Dioden der verschiedensten Art entwickelt worden sind. Auch Lichtquellen bspw. in Form von lichtemittierenden Halbleiterdioden, speziell Laserdioden, aber auch konventionelle Leuchtmittel, die in derartigen Gehäusen verfügbar sind, können vorteilhaft für die erfindungsgemäße Vorrichtung Verwendung finden, d.h. Lichtquellen in einem Gehäuse nach Art eines integrierten Schaltkreises aufnehmen, oder sogar Lichtquellen, die kein gesondertes Gehäuse aufweisen und schließlich auch Lichtquellen, die in Form sog. Halbleiter-Chips ausgebildet sind.

Die Erfindung wird nun unter Bezugnahme auf die nachfolgenden schematischen Zeichnungen anhand eines Ausführungsbeispieles im einzelnen beschrieben. Darin zeigt
- Fig. 1: in stark schematisierter Form in der Seitenan- sicht im Schnitt eine erfindungsgemäße Vor- richtung,
- Fig. 2: die in Fig. 1 dargestellte Vorrichtung in der Draufsicht und
- Fig. 3: in perspektivischer Form ein Rohrelement, in dem gegenüberliegende, schlitzförmig ausgebil- dete Blenden vorhanden sind.

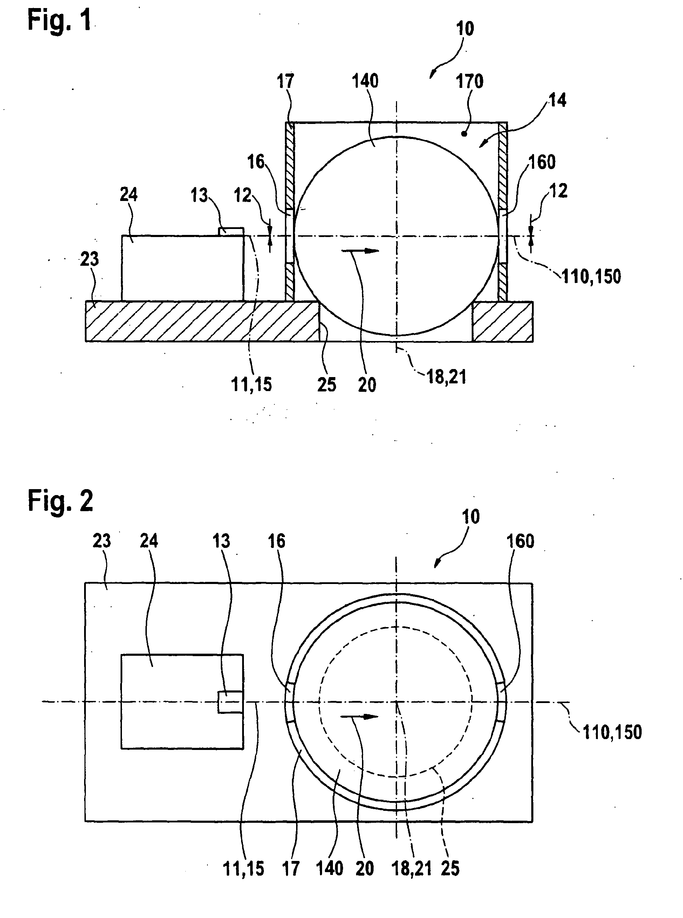

Es wird zunächst Bezug genommen auf die Darstellung der Vorrichtung 10 in den Fig. 1 und 2. Die Vorrichtung 10 umfaßt ein plattenförmiges Trägerelement 23, das hier aber nur stellvertretend für alle möglichen Ausgestaltungen eines Trägerelementes 23 dargestellt ist, wobei das Trägerelement 23 sich in bezug auf Form sowie in bezug auf den bzw. die das Trägerelement bildenden Werkstoff bzw. Werkstoffe sich nach den räumlichen, mechanischen und elektrischen Gegebenheiten richtet, in denen die Vorrichtung 10 bzw. mit denen zusammen die Vorrichtung 10 angeordnet bzw. betrieben wird. Wichtig ist, daß das Trägerelement 23 mechanisch hinreichend stabil ist, so daß ein die Vorrichtung 10 verlassender Lichtstrahl 110 in bezug auf seinen Strahlengang 150 hinreichend stabil ist.

Die Vorrichtung 10 umfaßt eine Lichtquelle 13, die in Form einer in einem sog. TO-Gehäuse angeordnete Laserdiode ausgebildet sein kann, die hier auf einen Zwischenträger zur Wärmeisolierung montiert ist, sowie eine kugelförmig ausgebildete Linse 140. In einem bestimmten Abstand von der Lichtquelle 13 ist die Linse 140 angeordnet. Dieser Abstand bemißt sich nach den physikalischen Gegebenheiten der Art des Austritts des Lichts aus der Lichtquelle 13 sowie der optisch-geometrischen Ausgestaltung der kugelförmigen Linse 140 und dem linsenbildenden Werkstoff. Diese Größen sind, physikalisch bedingt, der Fachwelt prinzipiell bekannt und bedürfen hier keiner weiteren Erörterung.

In dem Trägerelement 23 ist ein Loch 25 ausgebildet, und zwar im wesentlichen rechtwinklig zur Achse des Strahlenganges 15 der von der Lichtquelle 13 auf die Linse 140, die hier die Focussierungseinrichtung 14 bildet, Lichtstrahlen 11. Das Loch 25 ist im wesentlichen kreisförmig ausgebildet, so daß die Linse 140 sich an dem Orte des Loches 25 selbständig zentriert. In dieser Stellung auf dem Loch 25 aufliegend wird die Linse 140 auf einfache Weise, bspw. mittels einem Klebemittel, fixiert.

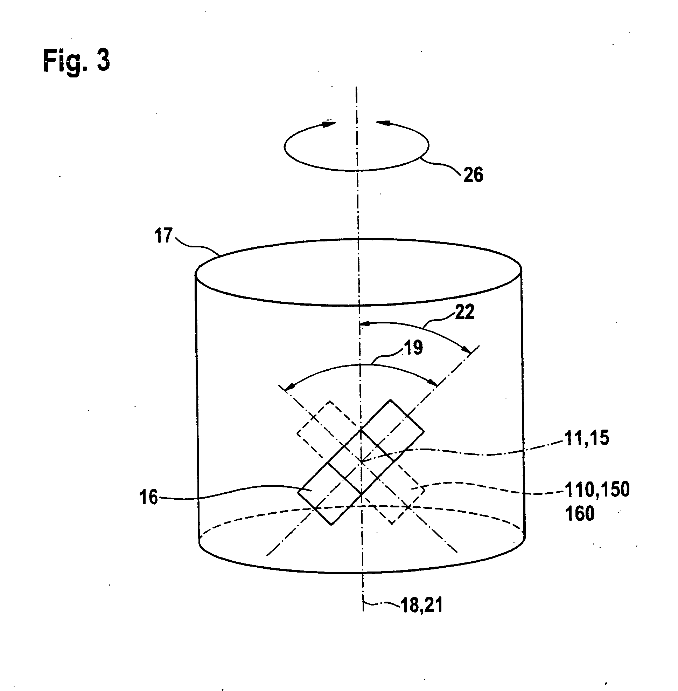

Ein rohrförmiges Blendenelement 17 ist quasi über die kugelförmige Linse 140 übergestülpt, wobei die Abmaße des Innenraums 170 des Rohrelements 17 derart bemessen sind, daß die kugelförmige Linse 140 zwar spielfrei im Innenraum 170 aufgenommen wird, aber noch relativ zur an sich im Loch 25 fixierten Linse 140 um einen Winkel entsprechend dem Pfeil 26 von Fig. 3 gedreht werden kann. In dem Rohrelement 17 sind in Richtung des Strahlenganges 15 beidseitig jeweils eine schlitzförmig ausgebildete Blende 16, 160 in Form von Durchbrechungen der Rohrwandungen ausgebildet, und zwar genauer in dem Strahlengang 15 zwischen Linse 140 und Lichtquelle 13 und im Strahlengang 150 nach der Linse 140.

Ein nach Art eines integrierten Schaltkreises ausgebildeter Schaltkreisträger 24, sog. "Submount", der der Wärmeableitung dient, der auch die Lichtquelle 13 umfaßt, ist auf dem Trägerelement 23 angeordnet, und zwar derart, daß die aus der Lichtquelle 13 in Richtung des Strahlenganges 20, hier symbolisch zur Darstellung der Richtung mit Pfeil 20 bezeichnet, austretenden Lichtstrahlen 11 im Idealfall zentrisch durch die erste Blende 16 hindurchtreten und zentrisch durch die zweite Blende 160 hindurchtreten, d.h. durch die Linse 140 hindurch und aus dieser dann heraus.

Aus Fig. 3 ist gut ersichtlich, daß der blendenbildende Schlitz 16 auf der der Lichtquelle 13 zugewandten Seite der Focussierungseinrichtung 14 bzw. der Linse 140 gegenüber einer zur Richtung 20 des Strahlenganges 15, 150 Orthogonalen 21 um einen Winkel 22 gedreht ist, wobei der Winkel 22 hier im wesentlichen im Bereich von 90° groß ist. Der auf der anderen Seite, d.h. der gegenüberliegenden Seite des Schlitzes 16 ausgebildete Schlitz 160 ist gegenüber dem Schlitz 16 um einen im wesentlichen im Bereich von 45° liegenden Winkel 19 gedreht.

Toleranzen, hervorgerufen durch fertigungsbedingte Schwankungen der Lichtabgabeebene bzw. des Lichtabgaberaumwinkels des die Lichtquelle verlassenden Lichtstrahls 11 bzw. 110 sowie Fertigungstoleranzen der Vorrichtung 10 einschließlich des Trägerelementes 23 sowie Linsenfehler der kugelförmigen Linse 140 und auch ihrer Positionierung im Loch 25 des Trägerelementes 23 tragen dazu bei, daß der Lichtstrahl 11 nach der Fertigung der Vorrichtung 10 tatsächlich nicht in der gewünschten Form der Lichtstrahlen 110, die die Vorrichtung 10 verlassen sollen, aus dieser austritt. Durch Drehung des Rohrelementes 17, vgl. Fig. 3, in Richtung des Pfeiles 26 können Lichtstrahlenanteile, die nicht gewünscht werden, d.h. die aus der gewünschten Richtung herausfallen würden, auf einfache Weise, d.h. quasi nur mit einer Drehung des Rohrelementes 17, ausgeblendet werden, so daß, wie angestrebt, ein richtungstabiler, linearer Lichtstrahl 110 mit angestrebt geringer lateraler Ausbreitung die Vorrichtung 10 zu verlassen imstande ist. Ebenfalls durch die Blenden 16, 160 können auch die Linsenfehler korrigiert werden, quasi als Nebenprodukt der erfindungsgemäßen Vorrichtung 10.

Die laterale Ausdehnung des die Vorrichtung 10 verlassenden Lichtstrahls 111 liegt im wesentlichen im Bereich von 0,5 - 1 mm, wobei aber darauf hingewiesen wird, daß natürlich auch andere Größen bzw. Werte mit der Vorrichtung 10 ausgebildet werden können.

### Bezugszeichenliste

- 10: Vorrichtung
- 11: Lichtstrahl
- 110: Lichtstrahl
- 12: laterale Ausbreitung
- 13: Lichtquelle
- 14: Focussierungseinrichtung
- 140: Linse (kugelförmige Linse)
- 15: Strahlengang
- 150: Strahlengang
- 16: Blende (schlitzförmig ausgebildete Blende)
- 160: Blende (schlitzförmig ausgebildete Blende)
- 17: Rohrelement 170 Innenraum (des Rohrelementes)
- 18: Drehachse (Längsachse des Rohrelements)
- 19: Winkel (erster Winkel) im Bereich von 45°
- 20: Strahlengangrichtung
- 21: Orthogonale
- 22: Winkel (zweiter Winkel) im Bereich von 90°
- 23: Trägerelement
- 24: Schaltkreisträger (Submount)
- 25: Loch
- 26: Pfeil

## Patentansprüche

1. Vorrichtung (10) zur Erzeugung eines im wesentlichen linearen Lichtstrahls (11) mit geringer lateraler Ausbreitung (12), umfassend eine Lichtquelle (13), deren Lichtstrahlen (110) auf eine Focussierungseinrichtung (14) geleitet werden und im Strahlengang (15) zwischen Linse (140) und Lichtquelle (13) und im Strahlengang (150) nach der Linse (140) jeweils eine schlitzförmig ausgebildete Blende (16, 160) angeordnet ist, wobei die die Focussierungseinrichtung in Form der Linse verlassenden Lichtstrahlen (110) das gewünschte Licht bilden, **dadurch gekennzeichnet, daß** die Linse (140) in Form einer Kugel ausgebildet ist und die schlitzförmig ausgebildeten Blenden (16, 160) in einem Rohrelement (17) mit kreisförmigem Querschnitt angeordnet sind, in dessen Innenraum (170) die kugelförmige Linse (14) spielfrei aufgenommen ist, wobei das Rohrelement (17) relativ zur Linse (140) um seine im wesentlichen orthogonal zur Achse des Strahlenganges (15, 150) verlaufende Längsachse (18) drehbar ist und die Blende (16, 160) in Form einer Durchbrechung der Rohrwandung ausgebildet ist.

2. Vorrichtung nach Anspruch 1, worin, die Lichtquelle (13) eine Laserlichtquelle ist.

3. Vorrichtung nach Anspruch 2, worin, die Laserlichtquelle eine Laserdiode ist.

4. Vorrichtung nach einem oder mehreren der Ansprüche 1 bis 3, worin der blendenbildende Schlitz (16) auf der einen Seite der Focussierungseinrichtung (14) gegenüber den auf der anderen Seite der Focussierungseinrichtung (14) angeordneten Schlitz (160) um einen im wesentlichen im Bereich von 90° liegenden Winkel (22) gedreht ist.

5. Vorrichtung nach.einem oder mehreren der Ansprüche 1 bis 4, worin der blendenbildende Schlitz (16) auf der der Lichtquelle (13) zugewandten Seite der Focussierungseinrichtung (14) gegenüber der Längsachse (18) der Rohrelements (17) um einen Winkel (19) gedreht ist.

6. Vorrichtung nach Anspruch 5, worin, der Winkel (19) im wesentlichen im Bereich von 45° groß ist.

7. Vorrichtung nach einem oder mehreren der Ansprüche 1 bis 6, worin wenigstens die Kugellinse (140) in einem in einem Trägerelement (23) ausgebildeten, im wesentlichen kreisförmigen Loch (25) aufgenommen ist.

8. Vorrichtung nach Anspruch 7, worin, auf dem Trägerelement (23) ebenfalls die Lichtquelle (13) angeordnet ist.

9. Vorrichtung nach einem oder mehreren der Ansprüche 1 bis 8, worin die Lichtquelle (13) in einem Gehäuse nach Art eines im wesentlichen der Kühlung der Lichtquelle (13) dienenden Submounts aufgenommen wird.

## Claims

1. Device (10) for generating a largely linear beam of light (11) with low lateral spread (12), containing a light source (13) whose beams of light (110) are guided to a focusing device (14) and slit-shaped apertures (16, 160) are arranged in the beam path (15) between the lens (140) and the light source (13) and in the beam path (150) after the lens (140), with the beams of light (110) that leave the focusing device in the shape of the lens forming the desired light, **characterised in that** the lens (140) is executed in the shape of a sphere and the slit-shaped apertures (16, 160) are arranged in a tubular element (17) with a circular cross-section, in the interior of which (170) the spherical lens (14) is received without play, with the tubular element (17) being rotatable relative to the lens (140) around its longitudinal axis (18) that runs largely orthogonally to the axis of the beam path (15, 150), and with the aperture (16, 160) being executed in the form of an opening of the tubing wall.

2. Device according to claim 1, in which the light source (13) is a laser light source.

3. Device according to claim 2, in which the laser light source is a laser diode.

4. Device according to one or more of claims 1 to 3, in which the aperture-forming slit (16) on the one side of the focusing device (14) is rotated in relation to the slit (160) arranged on the other side of the focusing device (14) through an angle (22) largely in the region of 90°.

5. Device according to one or more of claims 1 to 4, in which the aperture-forming slit (16) on the side of the focusing device (14) facing the light source (13) is rotated in relation to the longitudinal axis (18) of the tubular element (17) through an angle (19).

6. Device according to claim 5, in which the angle (19) is largely in the region of 45°.

7. Device according to one or more of claims 1 to 6, in which at least the spherical lens (140) is received in a largely circular hole (25) executed in a carrier element (23).

8. Device according to claim 7, in which the light source (13) is also arranged on the carrier element (23).

9. Device according to one or more of claims 1 to 8, in which the light source (13) is received in a housing in the manner of a submount largely serving to cool the light source (13).

## Revendications

1. Dispositif (10) pour produire un faisceau lumineux (10) sensiblement linéaire, ayant une faible extension latérale (12), comprenant une source de lumière (13), dont les rayons lumineux (110) sont envoyés sur un dispositif de focalisation (14), un diaphragme configuré en forme de fente (16, 160) étant disposé tant sur la trajectoire des rayons (15) entre la lentille (14) et la source de lumière (13) que sur la trajectoire des rayons (150) après la lentille (14), les rayons lumineux (110) quittant le dispositif de focalisation sous forme de la lentille formant la lumière souhaitée, **caractérisé en ce que** la lentille (140) est configurée sous forme d'une sphère, et les diaphragmes configurés en forme de fente (16, 160) sont disposés dans un élément tubulaire (17) ayant une section transversale circulaire, dans l'espace intérieur (170) duquel la lentille sphérique (14) est logée sans jeu, l'élément tubulaire (17) pouvant tourner par rapport à la lentille (140) autour de son axe longitudinal (18), courant sensiblement perpendiculairement à l'axe de la trajectoire des rayons (15, 150), le diaphragme (16, 160) étant configuré sous forme d'une percée aménagée dans la paroi tubulaire.

2. Dispositif selon la revendication 1, dans lequel la source de lumière (13) est une source de lumière laser.

3. Dispositif selon la revendication 2, **caractérisé en ce que** la source de lumière laser est une diode laser.

4. Dispositif selon l'une ou plusieurs des revendications 1 à 3, dans lequel la fente (16) formant le diaphragme est tournée d'un angle (22) sensiblement de l'ordre de 90° sur une face du dispositif de focalisation (14), par rapport à la fente (160) disposée sur l'autre face du dispositif de focalisation (14).

5. Dispositif selon l'une ou plusieurs des revendications 1 à 4, dans lequel la fente (16) formant un diaphragme est tournée d'un angle (19) sur la face, dirigée vers la source de lumière (13), du dispositif de focalisation, par rapport à l'axe longitudinal (18) de l'élément tubulaire (17).

6. Dispositif selon la revendication 5, dans lequel l'angle (19) est sensiblement de l'ordre de 45°.

7. Dispositif selon l'une ou plusieurs des revendications 1 à 6, dans lequel au moins la lentille sphérique (140) est logée dans un trou sensiblement circulaire (25), aménagé dans un élément support (23).

8. Dispositif selon la revendication 7, dans lequel la source de lumière (13) est elle aussi disposée sur l'élément support (23).

9. Dispositif selon l'une ou plusieurs des revendications 1 à 8, dans lequel la source de lumière (13) est logée dans un boîtier du type d'une embase servant sensiblement au refroidissement de la source de lumière (13).
